# EUROPEAN PATENT SPECIFICATION

(11) **EP 2 420 589 B1**
(45) Date of publication and mention of the grant of the patent: **20.03.2013**
(21) Application number: 10173347.5
(22) Date of filing: 19.08.2010
(51) Int. Cl.: C23C 14/34, H01J 37/34

(54) **Hollow target assembly**
Hohltargetanordnung
Ensemble de cible creuse

(43) Date of publication of application: 22.02.2012
(73) Proprietor: Solar Applied Materials Technology Corp., Annan Dist , Tainan (TW)
(72) Inventor: Wu, Chung-Han, Tainan City (TW); Lai, Kuan-Ting, Tainan City (TW); Wang, Tzu-Wen, Tainan City (TW)
(74) Representative: Säfsten, Karin

(56) References cited:
- DE-A1-102004 031 161
- US-A1- 2002 041 158
- US-A1- 2005 224 342

## Description

### 1. Field of the Invention

The present invention relates to a sputtering target assembly, especially a hollow target assembly using elastic elements to provide good adhesiveness between the support tube and the target body.

### 2. Description of the Prior Arts

The sputtering efficiency of conventional plane target is only from 15% to 40%, which makes it unsuitable for large area deposition. To reduce cost, the rotating target is widely used in large area deposition in place of the plane target because the sputtering efficiency of the rotating target can reach 70% to 90%.

A rotating target normally comprises a target body and a support tube. The target body covers the outer circumferential surface of the support tube. The target body will generate large amount of heat during the deposition, and the heat needs to be conducted to the cooling medium via the support tube. Therefore, sufficient contact area between the support tube and the target body is necessary to provide good heat conduction. Conventionally, metals with low melting point will be filled to the gap between the target body and the support tube so they can contact with each other nicely. However, the cost for the metals having low melting point is too high, and the inside surface of the target body and the outside surface of the support tube need further metallization. Furthermore, during the deposition and cooling processes, cracks may generate between the target body and the support tube because they have different heat expansion coefficient.

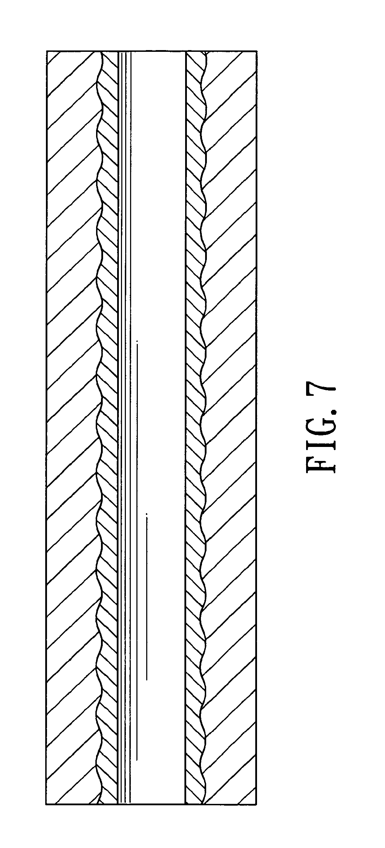

To solve the above-mentioned problem, US 2008/0003385A and WO 2009/036910A1 disclose a support tube that includes a meshing part consisting of at least either a protruding shape or a recessed shape at the interface between the support tube and the target body, as shown in Fig. 7. The target body is adhered with the support tube by heat treatment or casting. However, the equipment for heat treatment is expensive and will accordingly increase the production cost. Further, cracks and peelings may occur when the thermal expansion coefficient difference between the support tube and the target body is too large and causes too much stress on the meshing part. When using casting technique to form the target body, the high casting temperature and long time cooling cause the density of the target body to decrease and the microstructure of the target body not uniform so the quality of the deposited film is not good.

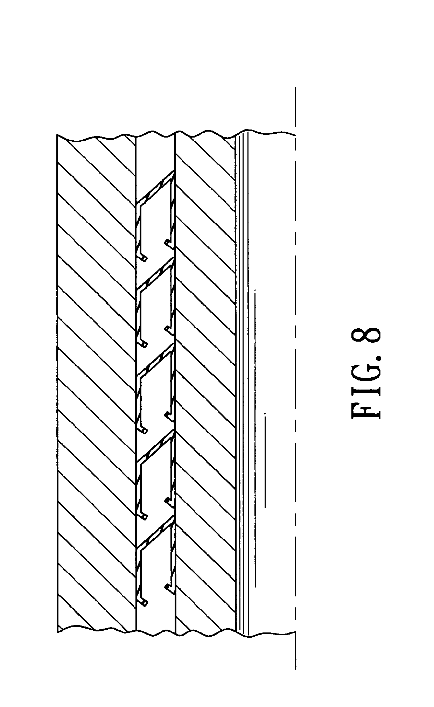

US 2009/0152108A1 discloses a target arrangement using elastic elements to overcome the gap generated between the support tube and the target body, as shown in Fig. 8. However, the support tube and the target body are adhered to each other by the friction of the elastic elements. If not enough elastic elements are used, the friction provided by the elastic elements may not be enough to prevent the target body from moving. How to put enough elastic elements into the gap between the support tube and the target body is a very complicated technique.

DE102004031161 discloses a target assembly for sputtering processes. However, the target assembly cannot effectively prevent the target material from moving relative to the supporting tube. US2002/041158 discloses a target assembly that employs balls and springs to prevent the target material from moving relative to the supporting tube. However, the ball easily slips or rolls to result in the relative motion between the supporting tube and target material. Putting the ball into the gap between the supporting tube and the target body is also a very complicated technique. US2005/224342 discloses a target assembly having a clamping element mounted between the target material and the supporting tube. However, the rounded insertion segment of the clamping element does not provide sufficient friction, and therefore easily slips relative to the target material so that axially relative motion always happens between the supporting tube and the target material.

The purpose of the present invention is to provide a hollow target assembly to improve the drawbacks of high cost, complicated process, bad contact between the target body and the support tube, and bad quality of the film deposited by the target material.

To achieve the aforesaid purpose, the present invention provides a hollow target assembly as indicated in independent claim 1, comprising:
a support tube having a head end and a tail end, and concaves formed respectively on the outer surface of the tube at the position close to the head end and the tail end;
a target body having at least a first hollow target material and a second hollow target material, and grooves are respectively formed on the inner surface of the first and second hollow target materials from their one ends over the axial direction so an open formed on said ends of the first and the second hollow target materials; and
a plurality of elastic elements;
wherein the first and second hollow target materials cover the outer circumferential surface of the support tube sequentially and open on the first and second hollow target materials respectively facing the head end and the tail end of the support tube so spaces are formed by the grooves on the inner surface of the first and second hollow target materials and the corresponding concaves on the outer surface of the head and tail end of the support tube, an elastic element is leaned and positioned in each space. Particular embodiments of the invention are indicated in dependent claims 2-7.

Preferably, the target body further comprises at least a third hollow target material and said third hollow target material is positioned between the first and the second target material. The third hollow target material forms grooves in the inner surface from one end over the axial direction and corresponding concaves formed on the outer surface of the support tube so the elastic elements are put in the spaces formed by the grooves and corresponding concaves.

Preferably, the first hollow target material further forms grooves on the end close to the third hollow target material over the axial direction and corresponding concaves formed on the outer surface of the support tube so the elastic elements are put in the spaces formed by the grooves and corresponding concaves.

The elastic element is a resilient sheet and its one end is placed in the groove and the other end is placed in the corresponding concave. In one embodiment, the grooves on the first, second and third target materials are respectively a continuous loop and the concave on the support tube is a continuous loop. In another embodiment, the grooves on the first, second and third target materials are respectively a discontinuous loop and the concave on the support tube is a continuous loop.

In one embodiment, the grooves on the first, second and third target materials are respectively a discontinuous loop and the concave on the support tube is a continuous loop.

### IN THE DRAWINGS

Fig. 1 is the cross-section view of the first preferred embodiment of the hollow target assembly of the present invention;
Fig. 2 is the cross-section view of the second preferred embodiment of the hollow target assembly of the present invention;
Fig. 3 is the cross-section view of the third preferred embodiment of the hollow target assembly of the present invention;
Fig. 4 is the cross-section view of an alternate hollow target assembly;
Fig. 5 is the top view of the fifth preferred embodiment of the hollow target assembly of the present invention;
Fig. 6 is the top view of the sixth preferred embodiment of the hollow target assembly of the present invention;
Fig. 7 is a cross-section view of one hollow target in the prior art;
Fig. 8 is a cross-section view of another hollow target in the prior art.

The above and other technical features and advantages of the present invention will be described in greater detail with reference to the drawings.

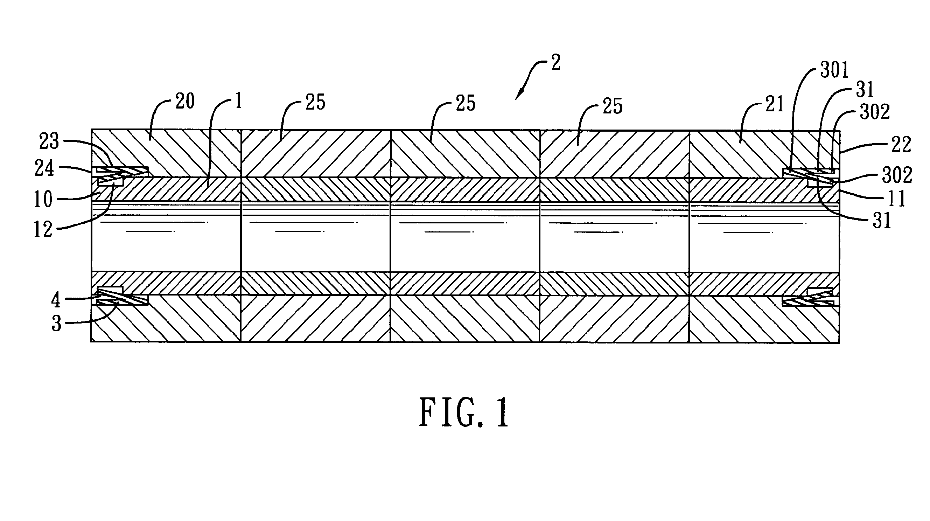

To reduce the manufacture cost of the rotating target material and to improve the contact between the support tube and the target body, the present invention provides a hollow target assembly comprising a support tube 1, a target body 2 and a plurality of elastic elements 3 as shown in Fig. 1.

The support tube 1 has a head end 10 and a tail end 11. Concaves 12 are formed respectively on the outer surface of the support tube 1 at the positions close to the head end 10 and the tail end 11. The concaves 12 are made as a continuous loop by machining, and the cross section shape of the concaves 12 is rectangular, triangular or of any other shapes.

The target body 2 comprises a first hollow target material 20 and a second hollow target material 21. Grooves 23 are respectively formed in the inner surface of the first hollow target material 20 and the second hollow target material 21 from one end 22 of said target materials over the axial direction so an open 24 is respectively formed on the first hollow target material 20 and the second hollow target material 21. The first and second hollow target materials 20, 21 cover the outer circumferential surface of the support tube 1 sequentially and open 24 on the first and second hollow target materials 20, 21 respectively facing the head end 10 and the tail end 11 of the support tube 1 so spaces 4 are formed by the grooves 23 on the inner surface of the first and second hollow target materials 20, 21 and the corresponding concaves 12 on the outer surface of the head end 10 and tail end 11 of the support tube 1.

Elastic elements 3 are leaned from the opens 24 on the first and second hollow target materials 20, 21 and placed in the spaces 4 formed by the grooves 23 and the corresponding concave 12. The support tube 1 and the target body 2 are brought together closely by these elastic elements 3.

After the first hollow target material 20 is put through and covers the support tube 1 and the elastic elements 3 are placed in the spaces 4 formed by the grooves 23 and the corresponding concaves 12, the first hollow target material 20 is heated up to the melting point of a metal. The melting metal is poured into the gap between the support tube 1 and the first hollow target material 20. The heat source is removed and the temperature of the first hollow target material 20 decreases gradually so the melting metal is coagulated and therefore the first hollow target material 20 and the support tube 1 can adhere together nicely. Afterwards, the second hollow target material 21 is treated in the same manner to adhere with the support tube 1 nicely. In this regard, although the different thermal expansion among the support tube 1, the target body 2 and the metal will cause gap generated between the support tube 1 and the target body 2 during the deposition or cooling process, the support tube 1 and the target body 2 still can maintain good adhesiveness with each other and the target body 2 will not shift by use of the elastic elements 3.

Preferably, the metal is metal having low melting point. More preferably, the metal is indium.

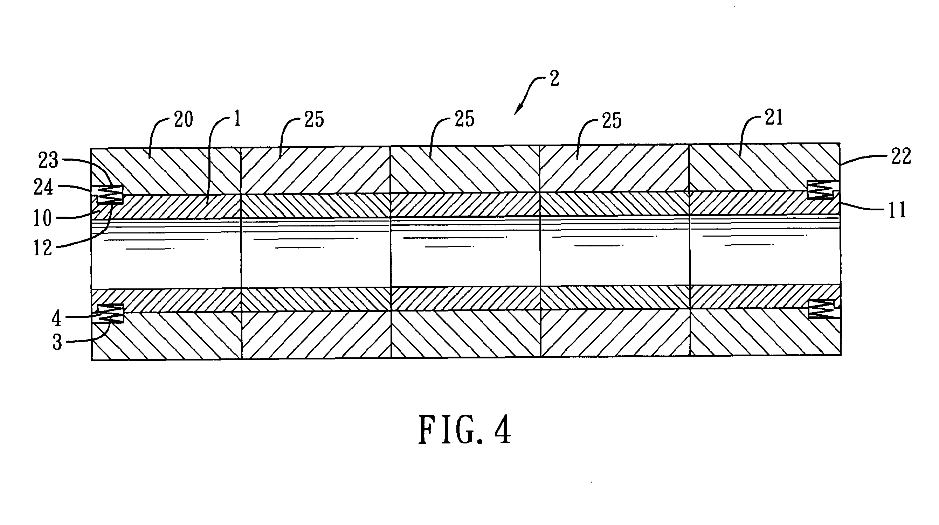

As shown in Fig. 1 and Fig. 4, the target body 2 further comprises at least a third hollow target material 25 between the first hollow target material 20 and the second hollow target material 21. The first hollow target material 20 firstly covers the outer circumferential surface of the support tube I and stays fixed by use of the elastic elements 3. The third hollow target material 25 is then put through the support tube 1. Finally, the second hollow target material 21 is put through the support tube 1 and stays fixed by use of the elastic elements 3. The amount of the third hollow target material 25 may vary depending on the length of the support tube 1. Since the first and second hollow target material 20, 21 stay in the fixed positions by the elastic elements 3, the third hollow target material 25 will also stay fixed in the middle of the target body 2 between the first and second hollow target materials 20, 21.

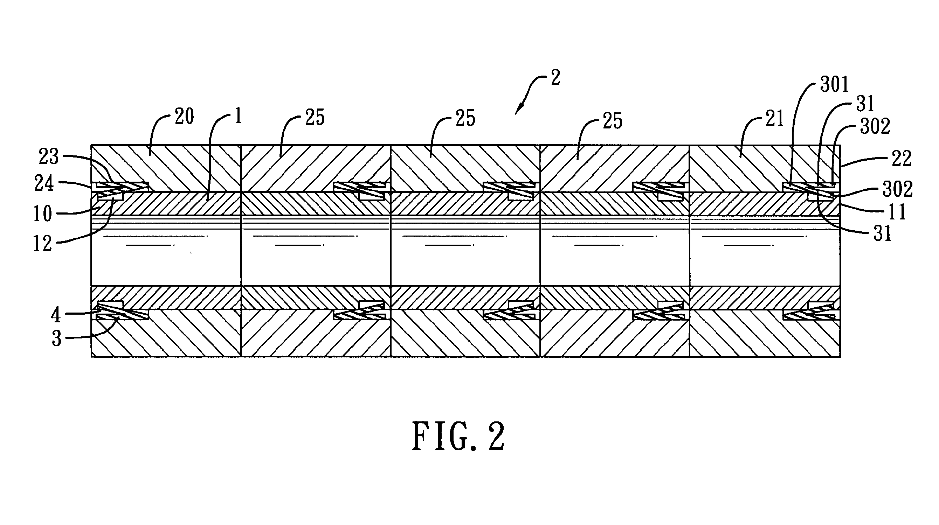

As shown in Fig. 2, the third hollow target materials 25 also form grooves 23 in the inner surface from one end 22 over the axial direction. The corresponding concaves 12 are also formed on the outer surface of the support tube 1. When the third hollow target materials 25 are put through the support tube 1, the end 22 having the grooves 23 faces the tail end 11 of the support tube 1. In this regard, the first, second and third hollow target material 20, 21, 25 have the grooves 23 for elastic elements 3 placement and accordingly enhance the adhesiveness between the target body 2 and the support tube 1 to provide more efficient heat conductivity.

During the assembly, the first hollow target material 20 is put through the support tube 1 and the elastic elements 3 are positioned in the spaces 4. The melting metal is poured into the gap between the support tube 1 and the first hollow target material 20. After the liquid metal coagulates, the third and second hollow target material 25, 21 are sequentially put through the support tube 1 in the same manner. That is, when each of the third or second hollow target material 25, 21 is put through the support tube 1, the elastic elements 3 are then positioned in the spaces 4 formed by the grooves 23 on each hollow target material and the corresponding concaves 12 on the support tube 1. Afterwards, the melting metal is poured in the gap between the hollow target material and the support tube 1 and cooled; the next third or second hollow target material 25, 21 is put through the support tube 1 for the same treatment.

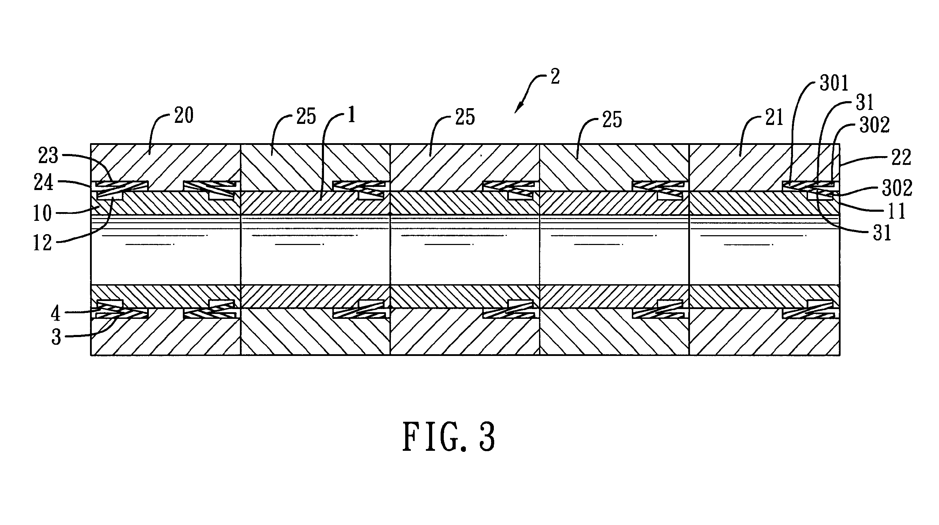

As shown in Fig. 3, the inner surface of the first hollow target material 20 further forms grooves 23 on the other end over the axial direction. The outer surface of the support tube 1 also forms concaves 12 at the corresponding position. The elastic elements 3 are put into the spaces 4 formed by the grooves 23 and the corresponding concaves 12 to enhance the adhesiveness between the target body 2 and the support tube 1.

The grooves 23 on the target materials provide spaces for elastic elements 3 placement. However, the grooves 23 should be as small as possible to prevent the impact to the target materials during the processing and to increase the use area of the target materials. The depth of the concave 12 in the circumferential direction is at least as thick as the elastic element 3, if not thicker, to provide sufficient resistance and prevent the displacement of the elastic element 3.

As shown in Fig.1 to Fig. 3, the elastic element 3 is a V-shaped resilient sheet. When the elastic element 3 is a V-shaped resilient sheet, the depth of the grooves 23 in the axial direction on the target materials is larger than the distance from the end of the concaves 12 to the nearest end of the support tube 1. Each V-shaped resilient sheet has two sheet members 31 obliquely connected at a first abutting end 301. Each sheet member 31 has a second abutting end 302 opposite to the first abutting end 301. The first abutting end 301 is placed in and presses against one of the grooves 23. One of the second abutting ends 302 is placed in and presses against one of the concaves 12 to prevent the supporting tube 1 from moving relative to the target body 2 along a first axial direction. The elastic elements 3 in the first hollow target material 20 are arranged symmetrically to the elastic elements 3 in the second hollow target material 21 so that the first abutting ends 301 of the elastic elements 3 in the first hollow target material 20 face along the first axial direction and the first abutting ends 301 of the elastic elements 3 in the second hollow target material 21 face along a second axial direction that is opposite to the first axial direction to prevent the target body 2 from moving along the first or second axial direction relative to the supporting tube 1.

As shown in Fig. 4, the elastic element 3 in an alternative to the invention is a spring. When the elastic element 3 is a spring, two ends of the spring respectively contact with the bottoms of the groove 23 and the corresponding concave 12.

The elastic element 3 preferably has good strength to support the target materials. The elastic element 3 preferably has good conductivity to conduct the heat from the target body 2 to the support tube 1. Preferably, the elastic element 3 is made by pure copper.

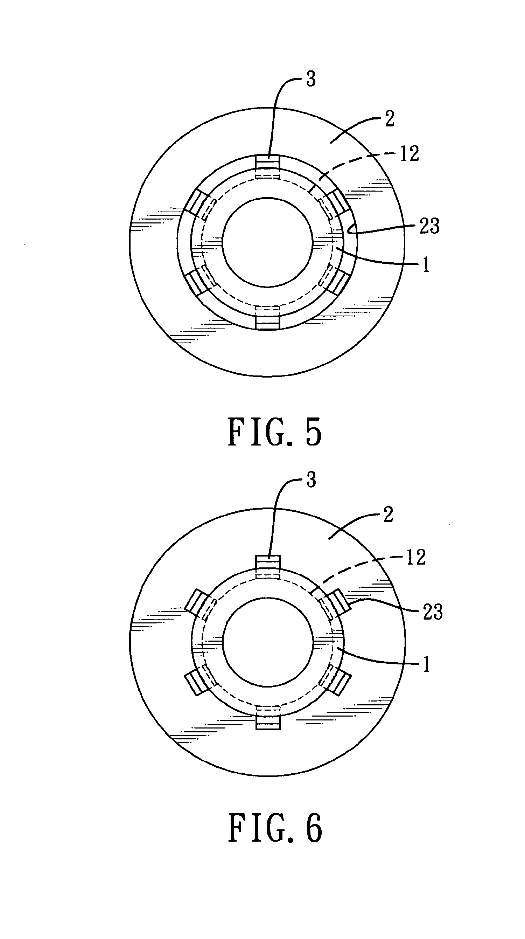

As shown in Fir.5, the groove 23 on the target material can be made as a continuous loop by machining. The groove 23 can also be made as a discontinuous loop (i.e. a plurality of grooves) as shown in Fig. 6.

### Example:

The aluminum zinc oxide is chosen as a sputtering material and forms a target body 2. The target body 2 contains one first hollow target material 20, one second hollow target material 21 and three third hollow target material 25. The outer diameter and the inner diameter of the three kinds of the hollow target materials are respectively 160 mm and 133 mm. Each length in the axial direction of the target materials is 280 mm so the total length of the target body 2 is 1400 mm. Grooves 23 are made as a continuous loop by machining in the inner surface of the first hollow target material 20 and the second hollow target material from an end 22 of said target materials with 10 mm depth in the axial direction and 2 mm in the circumferential direction. The support tube 1 is made by stainless SUS304. The outer diameter and inner diameter of the lined pipe 1 are respectively 132.5 mm and 125 nun. The length of the support tube 1 is 1450 mm. The outer diameter of the support tube 1 is 0.5 mm smaller than the inner diameter of the target body 2 so the target body 2 can easily cover the circumferential surface of the support tube 1. Concaves 12 are made by machining in the outer surface of the support tube 1 from the position close to the head end 10 and the tail end 11. The concaves 12 have triangle cross section shape, 3 mm length in the axial direction and 1 mm depth in the circumferential direction. The elastic elements 3 are made by pure copper with 1 mm thickness. The outer surface of the first, second and third hollow target materials 20, 21, 25 and the inner surface of the support tube 1 are metallized by immunization with melting indium.

The first hollow target material 20 is put through the support tube 1 and 6 elastic elements are put in the spaces formed by the grooves 23 and corresponding concaves 12. A heating blanket is used to cover the first hollow target material 20, and the temperature is kept at 180°C for 30 minutes so the temperature of the first hollow target material 20 is kept higher than the melting point of indium. The melting indium is poured into the gap between the first hollow target material 20 and the support tube 1. The heating blanket is removed and the melting indium is gradually coagulated. Afterwards, three third hollow target material 25 and the second hollow target material 21 are sequentially put through the support tube 1 and the step of placing the elastic elements 3 in the spaces formed by the grooves 23 and corresponding concaves 12 and the step of filling melting indium into the gap between the target material and the support tube 1 are repeated after each hollow target material is put through the support tube 1.

In conclusion, the hollow target assembly of the present invention uses the spaces 4 formed by the grooves 23 in the outer surface of the target materials and the corresponding concaves 12 in the inner surface of the support tube 1 for elastic elements 3 placement. The elastic elements 3 not only provide good heat conduction but also good adhesiveness between the target body 2 and the support tube 1.

## Claims

1. A hollow target assembly, comprising:
a support tube (1) having a head end (10) and a tail end (11), and concaves (12) formed respectively on the outer surface of the tube (1) at the position close to the head end (10) and the tail end (11);
a target body (2) having at least a first hollow target material (20) and a second hollow target material (21), and grooves (23) respectively formed on the inner surface of the first and second hollow target materials (20, 21) from their ends (22) over the axial direction so an open (24) is formed on said ends (22) of the first and the second hollow target materials (20, 21); and
a plurality of elastic elements (3);
wherein the first and second hollow target materials (20, 21) cover the outer circumferential surface of the support tube (1) sequentially and the open (24) on the first and second hollow target materials (20, 21) respectively facing the head end (10) and the tail end (11) of the support tube (1) so spaces (4) are formed by grooves (23) on the inner surface of the first and second hollow target materials (20, 21) and the corresponding concaves (12) on the outer surface of the head end (10) and tail end (11) of the support tube (1), and the elastic elements (3) are respectively leaned and positioned in each space (4);
wherein the hollow target assembly is **characterized in that**:
each elastic element (3) is a V-shaped resilient sheet and has two sheet members (31) obliquely connected at a first abutting end (301) and each sheet member (31) having a second abutting end (302) opposite to the first abutting end (301), the first abutting end (301) is placed in and presses against one of the grooves (23) and one of the second abutting ends (302) is placed in and presses against one of the concaves (12) to prevent the supporting tube (1) from moving relative to the target body (2) along an axial direction.

2. The hollow target assembly as claimed in claim 1, wherein the target body (2) further comprises at least a third hollow target material (25) and said third hollow target material (25) is positioned between the first and the second target material (20, 21).

3. The hollow target assembly as claimed in claim 2, wherein the third hollow target material (25) forms grooves (23) in the inner surface from one end (22) over the axial direction and corresponding concaves (12) formed on the outer surface of the support tube (1) so the elastic elements (3) are put in the spaces (4) formed by the grooves (23) and corresponding concaves (12).

4. The hollow target assembly as claimed in claim 3, wherein the first hollow target material (20) further forms grooves (23) on the end close to the third hollow target material (25) over the axial direction and corresponding concaves (12) formed on the outer surface of the support tube (1) so the elastic elements (3) are put in the spaces (4) formed by the grooves (23) and corresponding concaves (12).

5. The hollow target assembly as claimed in any claim of claims 1 to 4,
wherein the grooves (23) on the first, second and third target materials (20, 21, 25) respectively form a continuous loop and the concaves (12) on the support tube (1) form a continuous loop.

6. The hollow target assembly as claimed in claims 1 to 4, wherein the grooves (23) on the first, second and third target materials (20, 21, 25) respectively form a discontinuous loop and the concaves (12) on the support tube (1) form a continuous loop.

7. The hollow target assembly as claimed in claim 1, wherein the elastic elements (3) in the first hollow target material (20) are arranged symmetrically to the elastic elements (3) in the second hollow target material (21) so that the first abutting ends (301) of the elastic elements (3) in the first hollow target material (20) face along a first axial direction and the first abutting ends (301) of the elastic elements (3) in the second hollow target material (21) face along a second axial direction that is opposite to the first axial direction to prevent the target body (2) from moving along the first or second axial direction relative to the supporting tube (1).

## Patentansprüche

1. Hohle Targetanordnung mit:
einem Stützrohr (1) mit einem Kopfstück (10) und einem Endstück (11), und mit Höhlungen (12), die jeweils an der Außenfläche des Rohrs (1), in einer Position nahe zu dem Kopfstück (10) und dem Endstück (11) ausgebildet sind;
einem Targetkörper (2) mit mindestens einem ersten hohlen Targetmaterial (20) und einem zweiten hohlen Targetmaterial (21), und Nuten (23), die jeweils an der Innenfläche der ersten und zweiten hohlen Targetmaterialien (20, 21), von deren Enden (22) aus, über die Axialrichtung, ausgebildet sind, so dass eine Öffnung (24) an den Enden (22) der ersten und zweiten hohlen Targetmaterialien (20, 21) ausgebildet ist; und
einer Vielzahl an elastischen Elementen (3);
wobei die ersten und zweiten hohlen Targetmaterialien (20, 21) die äußere Umfangsfläche des Stützrohrs (1) sequenziell und die Öffnung (24) auf den ersten und
zweiten hohlen Targetmaterialien (20, 21), die dem Kopfstück (10) beziehungsweise dem Endstück (11) des Stützrohrs (1) zugewandt sind, überdecken, so dass durch Nuten (23) an der Innenfläche der ersten und zweiten hohlen Targetmaterialien (20, 21) und den korrespondierenden Höhlungen (12) Zwischenräume (4) an der Außenfläche des Kopfstücks (10) und Endstücks (11) des Stützrohrs (1) ausgebildet sind, und die elastischen Elemente (3) jeweils im jedem Zwischenraum (4) abgestützt und positioniert sind;
wobei die hohle Targetanordnung **dadurch gekennzeichnet ist, dass**:
jedes elastische Element (3) ein V-förmiges nachgiebiges Band ist und zwei Bandelemente (31) aufweist, die schräg mit einem ersten anstoßenden Ende (301) verbunden sind, und jedes Bandelement (31) ein zu dem ersten anstoßenden Ende (301) entgegengesetztes, zweites anstoßendes Ende (302) aufweist, das erste anstoßende Ende (301) in einer der Nuten (23) platziert ist und gegen diese drückt, und eines der zweiten anstoßenden Enden (302) in einer der Höhlungen (12) platziert ist und gegen diese drückt, um zu verhindern, dass sich das Stützrohr (1) entlang einer Axialrichtung relativ zu dem Targetkörper (2) bewegt.

2. Hohle Targetanordnung nach Anspruch 1, bei der der Targetkörper (2) ferner mindestens ein drittes hohles Targetmaterial (25) aufweist, und das dritte hohle Targetmaterial (25) zwischen dem ersten und dem zweiten Targetmaterial (20, 21) positioniert ist.

3. Hohle Targetanordnung nach Anspruch 2, bei der das dritte hohle Targetmaterial (25) in der Innenfläche von einem Ende (22) über die Axialrichtung Nuten (23) und korrespondierende, an der Außenfläche des Stützrohrs (1) ausgebildete Höhlungen (12) bildet, so dass die elastischen Elemente (3) in die durch die Nuten (23) und korrespondierenden Höhlungen (12) gebildeten Zwischenräume (4) eingesetzt sind.

4. Hohle Targetanordnung nach Anspruch 3, bei der das erste hohle Targetmaterial (20) ferner an dem Ende, das dem dritten hohlen Targetmaterial (25) nahe liegt, über die Axialrichtung Nuten und korrespondierende, an der Außenfläche des Stützrohrs (1) ausgebildete Höhlungen (12) bildet, so dass die elastischen Elemente (3) in die durch die Nuten (23) und korrespondierenden Höhlungen (12) gebildeten Zwischenräume (4) eingesetzt sind.

5. Hohle Targetanordnung nach einem der Ansprüche 1-4, bei der die Nuten (23) an den ersten, zweiten und dritten Targetmaterialien (20, 21, 25) jeweils eine kontinuierliche Schleife bilden, und die Höhlungen (12) an dem Stützrohr (1) eine kontinuierliche Schleife bilden.

6. Hohle Targetanordnung nach einem der Ansprüche 1-4, bei der die Nuten (23) an den ersten, zweiten und dritten Targetmaterialien (20, 21, 25) jeweils eine diskontinuierliche Schleife bilden, und die Höhlungen (12) an dem Stützrohr (1) eine diskontinuierliche Schleife bilden.

7. Hohle Targetanordnung nach Anspruch 1, bei der die elastischen Elemente (3) in den ersten hohlen Targetmaterialien (20) zu den elastischen Elementen (3) in dem zweiten hohlen Targetmaterial (21) symmetrisch angeordnet sind, so dass die ersten anstoßenden Enden (301) der elastischen Elemente (3) in dem ersten hohlen Targetmaterial (20) einander entlang einer ersten Axialrichtung zugewandt sind, und die ersten anstoßenden Enden (301) der elastischen Elemente (3) in dem zweiten hohlen Targetmaterial (21) einander entlang einer zweiten Axialrichtung zugewandt sind, die der ersten Axialrichtung entgegengesetzt ist, um zu verhindern, dass der Targetkörper (2) sich relativ zu dem Stützrohr (1) entlang der ersten oder zweiten Axialrichtung bewegt.

## Revendications

1. Ensemble cible creuse, comprenant :
un tube de support (1) comportant une extrémité de tête (10) et une extrémité de queue (11), et des parties concaves (12) formées respectivement sur la surface externe du tube (1) en la position proche de l'extrémité de tête (10) et l'extrémité de queue (11) ;
un corps de cible (2) comportant au moins un premier matériau de cible creuse (20) et un deuxième matériau de cible creuse (21), et des rainures (23) formées respectivement sur la surface interne des premier et deuxième matériaux de cible creuse (20, 21) depuis leurs extrémités (22) sur la direction axiale de manière qu'une partie ouverte (24) soit formée sur lesdites extrémités (22) des premier et deuxième matériaux de cible creuse (20, 21) ; et
une pluralité d'éléments élastiques (3) ;
les premier et deuxième matériaux de cible creuse (20, 21) recouvrant la surface circonférentielle externe du tube de support (1) séquentiellement et la partie ouverte (24) sur les premier et deuxième matériaux de cible creuse (20, 21) étant tournée respectivement vers l'extrémité de tête (10) et l'extrémité de queue (11) du tube de support (1) de manière que des espaces (4) soient formés par les rainures (23) sur la surface interne des premier et deuxième matériaux de cible creuse (20, 21) et les parties concaves (12) correspondantes sur la surface externe de l'extrémité de tête (10) et l'extrémité de queue (11) du tube de support (1), et les éléments élastiques (3) étant respectivement inclinés et positionnés dans chaque espace (4) ;
l'ensemble cible creuse étant **caractérisé en ce que** :
chaque élément élastique (3) est un élément élastique en forme de V et comporte deux éléments feuilles (31) reliés obliquement au niveau d'une première extrémité de butée (301) et chaque élément feuille (31) comportant une seconde extrémité de butée (302) opposée à la première extrémité de butée (301), la première extrémité de butée (301) est placée dans l'une des rainures (23) et presse contre l'une des rainures (23) et l'une des secondes extrémités de butée (302) est placée dans l'une des parties concaves (12) et presse contre l'une des parties concaves (12) pour empêcher que le tube de support (1) se déplace relativement au corps de cible (2) le long d'une direction axiale.

2. Ensemble cible creuse selon la revendication 1, dans lequel le corps de cible (2) comprend, en outre, au moins un troisième matériau de cible creuse (25) et ledit troisième matériau de cible creuse (25) est placé entre les premier et deuxième matériaux de cible creuse (20, 21).

3. Ensemble cible creuse selon la revendication 2, dans lequel le troisième matériau de cible creuse (25) forme des rainures (23) dans la surface interne depuis une extrémité (22) sur la direction axiale et des parties concaves (12) formées sur la surface externe du tube de support (1) de manière que les éléments élastiques (3) soient placés dans les espaces (4) formés par les rainures (23) et les parties concaves (12) correspondantes.

4. Ensemble cible creuse selon la revendication 3, dans lequel le premier matériau de cible creuse (20) forme, en outre, des rainures (23) sur l'extrémité proche du troisième matériau de cible creuse (25) sur la direction axiale et des parties concaves (12) correspondantes formées sur la surface externe du tube de support (1) de manière que les éléments élastiques (3) soient placés dans les espaces (4) formés par les rainures (23) et les parties concaves (12) correspondantes.

5. Ensemble cible creuse selon l'une quelconque des revendications 1 à 4, dans lequel les rainures (23) sur les premier, deuxième et troisième matériaux de cible creuse (20, 21, 25) forment, respectivement, une boucle continue et les parties concaves (12) sur le tube de support (1) forment une boucle continue.

6. Ensemble cible creuse selon l'une quelconque des revendications 1 à 4, dans lequel les rainures (23) sur les premier, deuxième et troisième matériaux de cible creuse (20, 21, 25) forment, respectivement, une boucle discontinue et les parties concaves (12) sur le tube de support (1) forment une boucle continue.

7. Ensemble cible creuse selon la revendication 1, dans lequel les éléments élastiques (3) dans le premier matériau de cible creuse (20) sont agencés symétriquement aux éléments élastiques (3) dans le deuxième matériau de cible creuse (21) de manière que les premières extrémités de butée (301) des éléments élastiques (3) dans le premier matériau de cible creuse (20) soient tournées le long d'une première direction axiale et les premières extrémités de butée (301) des éléments élastiques (3) dans le deuxième matériau de cible creuse (21) soient tournées le long d'une seconde direction axiale qui est opposée à la première direction axiale pour empêcher que le corps de cible (2) se déplace le long de la première ou la seconde direction axiale relativement au tube de support (1).
